(19) Europäisches Patentamt
European Patent Office
Office européen des brevets

(11) **EP 1 475 645 A1**

(12) **EUROPÄISCHE PATENTANMELDUNG**

(43) Veröffentlichungstag:
**10.11.2004   Patentblatt 2004/46**

(51) Int Cl.⁷: **G01R 31/333**

(21) Anmeldenummer: **03090137.5**

(22) Anmeldetag: **08.05.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **06.05.2003  DE**

(71) Anmelder: **Slamecka, Ernst**
**13595 Berlin (DE)**

(72) Erfinder: **Slamecka, Ernst**
**13595 Berlin (DE)**

(54) **Synthetische Prüfschaltung für Hochspannungs-Wechselstrom-Leistungsschalter**

(57)     Problemstellung

- fehlende galvanische Leitungsverbindung Prüfschalter - Hochstromenergiequelle für unbeschränkten Energienachschub bei Nachstromfluß, Konsequenz, IEC publication 60 427: "... it is necessary to demonstrate the validity of the test circuit for the interaction interval."

- Entzerren der synthetischen Einschwingspannung ohne schädliche Dämpfung der Einschwingspannung des Hochstromkreises

- Prüfschalter wird überbeansprucht durch stationäre Wiederkehrspannung ausschließlich als Erstlöschende-Polspannung

- Hilfsschalterbogenspannung soll kleiner sein als Prüfschalterbogenspannung gemäß IEC-Empfehlung

    Problemlösungen

- Hilfsschalter erhält parallelgeschaltet polaritätsabhängige Schalteinrichtung, realisiert durch Halbleiterbauelemente

- zeitlich abgestimmte Frequenzreduktion der Einschwingspannung des Hochstromkreises

- Rückführung der Erstlöschenden-Polspannung auf Phasenspannungshöhe durch Rückführungsstromkreis mit Schalteinrichtung

- Reduktion der Hilfsschalterbogenspannung durch Reduktion der Unterbrecherintensität des Hilfsschalters bei reduzierter Bogenenergie

    Nützlichkeit

- thermische und auch vollständige dielektrische Äquivalenz der synthetischen Schalterbeanspruchung ergibt u.a. ohne Abstriche anerkannte Prüfungsergebnisse, damit Sicherheit und Wirtschaftlichkeit von Entwicklung sowie Betrieb der Hochspannungsleistungsschalter erhöhend

- IEC-konform reduzierte Hilfsschalterbogenspannung erhöht - neben Beitrag zur thermischen Äquivalenz der Schalterbeanspruchung - Wirtschaftlichkeit der synthetischen Prüfanlage durch die Option: Hochstromkreis ohne Transformator

    Zu dieser Zusammenfassung gehört Fig. 1

EP 1 475 645 A1

Fig.1

**Beschreibung**

Die Erfindung betrifft synthetische Prüfschaltungen mit den im Oberbegriff des Anspruchs 1 genannten Merkmalen.

Bei der originären Prüfschaltung, Patentschrift DE 1 180 841, ist es noch erforderlich, für Prüfungen unter Klemmenkurzschlußbedingungen (terminal fault conditions) oder Abstandskurzschlußbedingungen (short-line-fault conditions ) "... to demonstrate the validity of the test circuit for the interaction interval." Wie soll dieser Nachweis erbracht werden? "This is subject to agreement between manufacturer, testing station and user." Siehe: IEC Publication 60427, Third edition, 2000-04, Seite 25: eine kaum zufriedenstellende Situation für eine synthetische Prüfschaltung in einem "International Standard".

Aus DE 1616359, Anmeldetag: 31.01.68, ist bekannt, den Hilfsschalter noch ein kurzes Zeitintervall über das Strom-Null des Hochstroms hinausreichend elektrisch leitend zu halten für ausreichenden Energienachschub aus dem Hochstromkreis, falls im Prüfschalter ein Nachstrom fließen sollte; siehe dort Figs. 1 und 2; dies geschieht durch Überlagern eines Schwingstroms, siehe Fig. 3c.

Diesen Schwingstrom erzeugt ein aktiver Schwingkreis, der dem Hilfsschalter kurz vor dem Strom-Null des Hochstroms parallel geschaltet wird durch eine Steuerung.

Abgesehen von Aufwand und möglicher Rückwirkung des Schwingkreises auf den Hochspannungskreis beim Erzeugen des zweiten Teils der Einschwingspannung gibt es ein noch gravierenderes Problem: Die Abstimmung (timing) der Zeitpunkte des Erlöschens des Hilfslichtbogens im Hilfsschalter und des Parallelschaltens des Hochspannungskreises zu diesen Schalter zum Erzeugen des zweiten Teils der Einschwingspannung, besteht doch zwischen beiden Vorgängen kein natürlicher Zusammenhang; und eine schlechte Abstimmung bedeutet: fehlerhaftes Funktionieren dieser synthetischen Prüfschaltung.

Mit dem vorstehend dargelegten Verfahren, den Prüfschalter transient elektrisch leitend mit dem Hochstromkreis (oder auch mit einem Hochspannungskreis) zu verbinden, befassen sich noch fünf andere Druckschriften, ohne eine zufriedenstellende Lösung bieten zu können:

DE 1616356, Anmeldetag: 28.02.68
DE 20 43 731, A. T.: 26.08.70
DE 24 43 407, A. T.: 11.09.74
DE 26 56 211, A. T.: 11.12.76
"A new synthetic test circuit for high-voltage circuit-breaker testing", report presented at the colloquium of CIGRE Study Committee 13, Sarajevo, May 1989

Demnach ergibt sich als Erfindungsaufgabe, für dieses Problem und noch weitere an späteren Stellen zu nennende Probleme bei der eingangs zitierten synthetischen Prüfschaltung fortschrittliche Lösungen zu entwickeln. Die Problemlösungen stellen sich in den kennzeichnenden Merkmalen des Hauptanspruchs 1 und der Nebenansprüche 2, 4.

Vorteilhafte Weiterbildungen sind in den Unteransprüchen beschrieben.

Die Erfindungen werden anhand von Ausführungsbeispielen näher erläutert.

Die nachstehend angeführten Figuren zeigen:

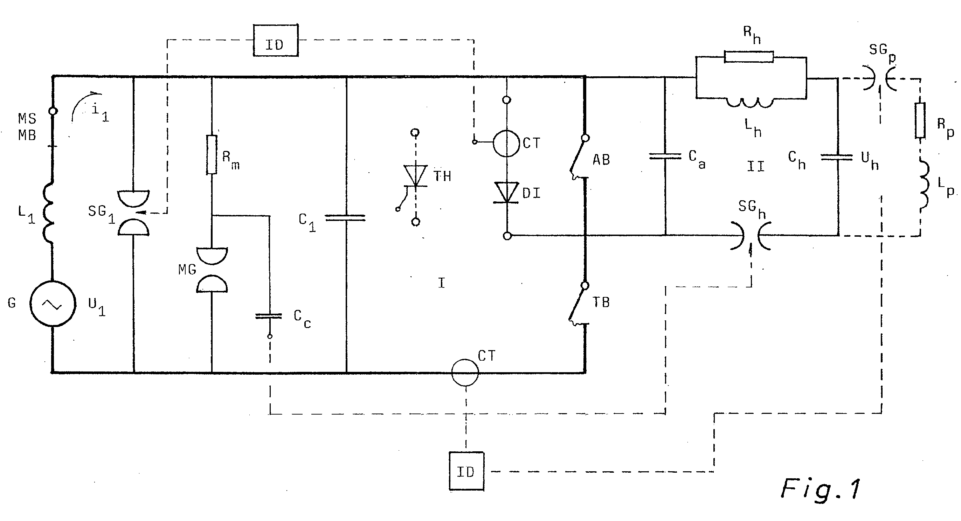

Fig. 1: Schaltplan der synthetischen Prüfschaltung

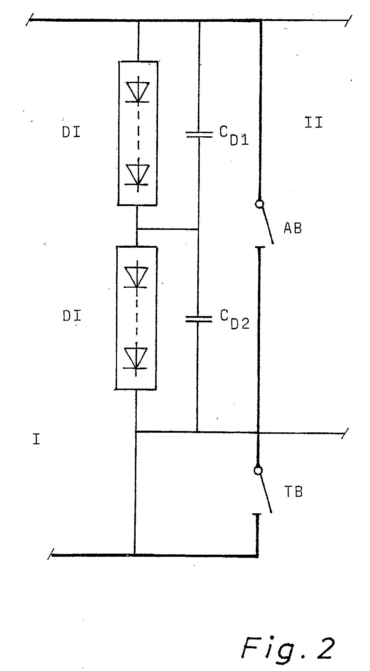

Fig. 2: Trag- und Isolierröhren für Halbleiterdioden in Zweifach-Reihenschaltung mit kapazitiver Spannungssteuerung

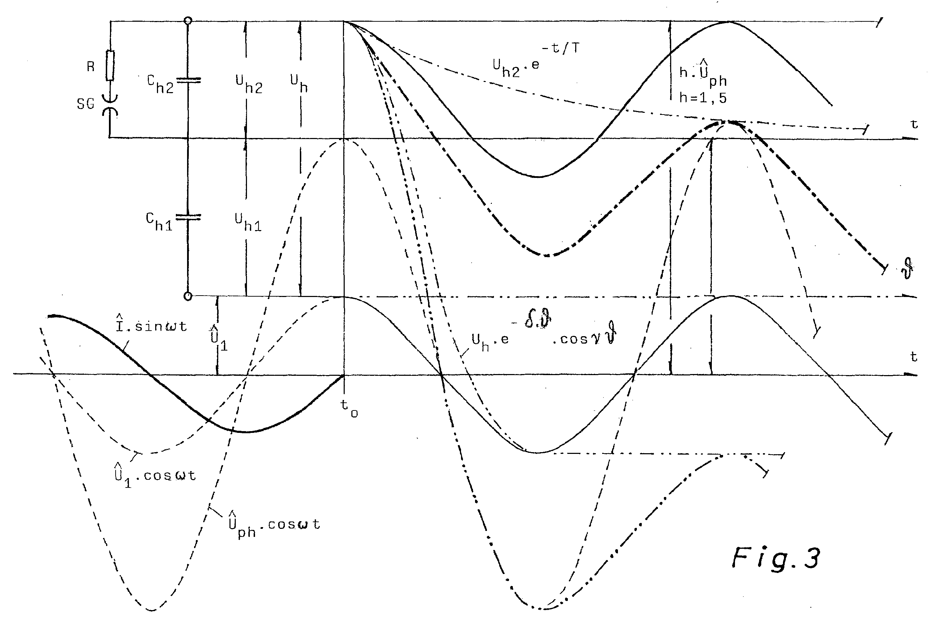

Fig. 3: Verlauf typischer stationärer wiederkehrender Spannungen; oben links im Bild: Baugruppe (module) zur aperiodische gedämpften Entladung eines Teils der Kondensatorbatterie $C_h$

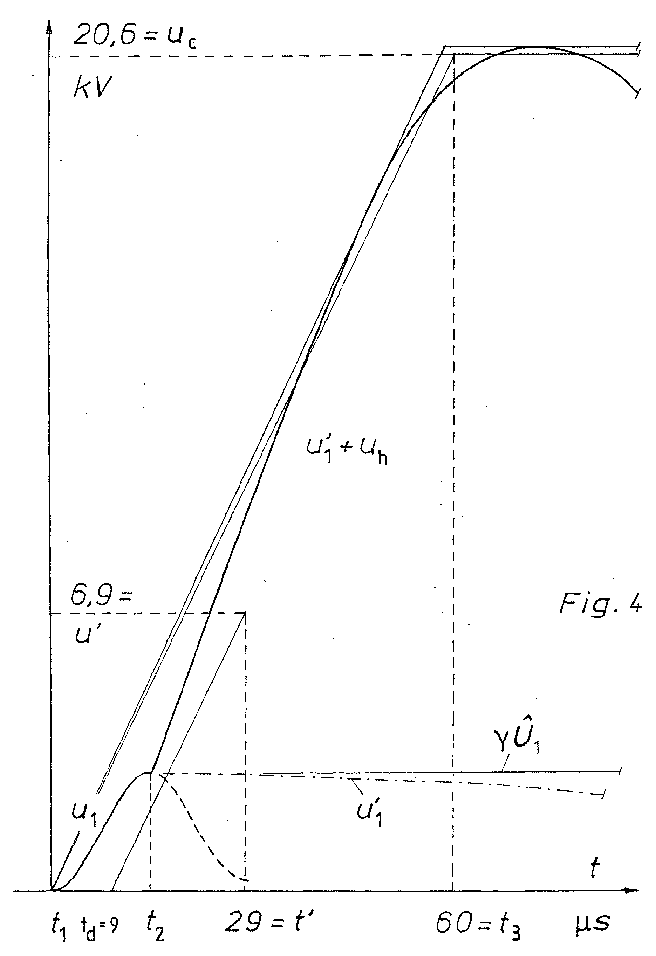

Fig. 4: Verlauf von Teilspannungen und der resultierenden synthetischen Einschwingspannung

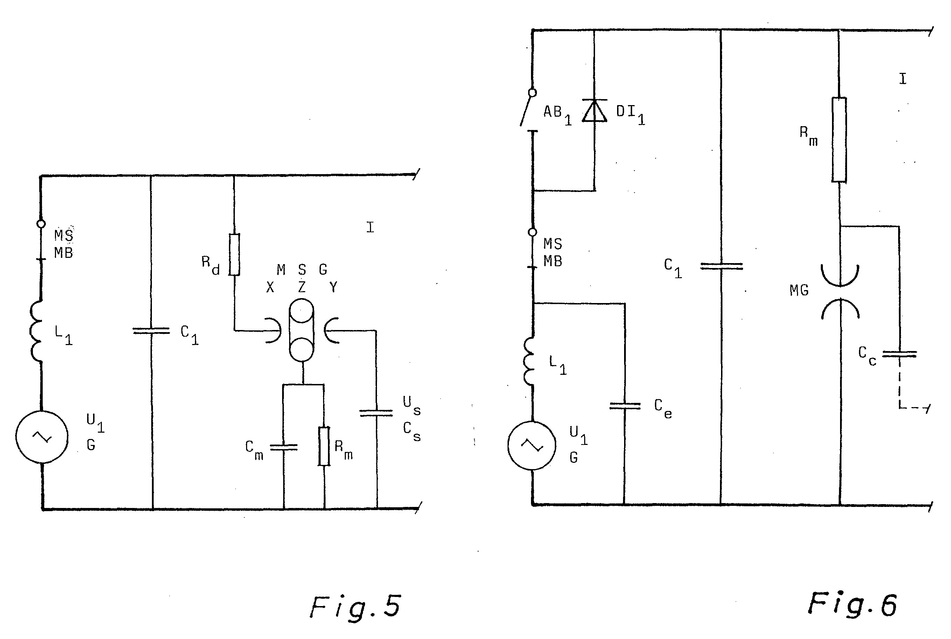

Fig. 5: Baugruppe (module) zur Glättung des Verlaufs der resultierenden synthetischen Einschwingspannung durch Glättungskapazität (smoothing capacitance) im Hochstromkreis I (Fig. 1)

Fig. 6: Baugruppe zur Glättung des Verlaufs der resultierenden synthetischen Einschwingspannung durch Glättungs-Halbleiterdiode im Hochstromkreis I (Fig. 1)

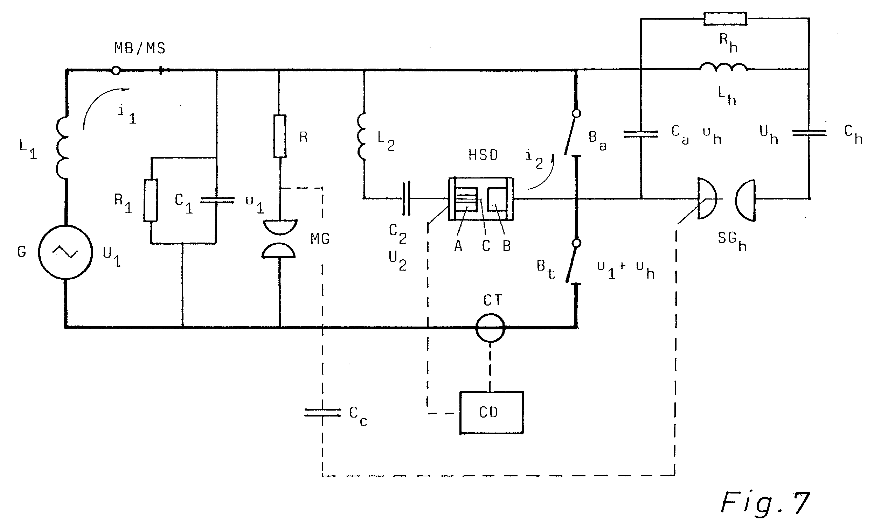

Fig. 7: Schaltplan der synthetischen Prüfschaltung mit Schwingkreis für Gegenstrom

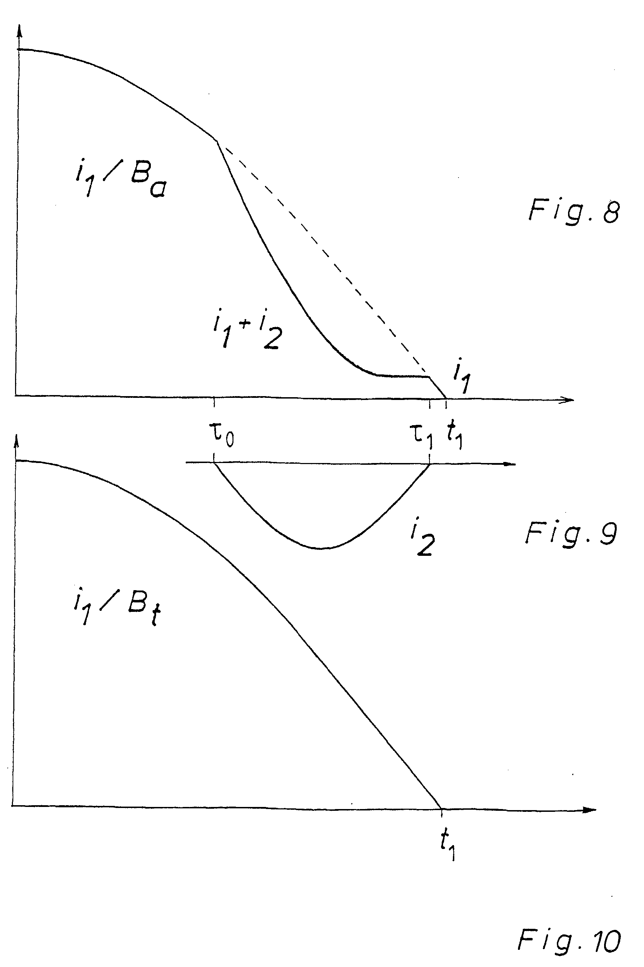

Fig. 8: Hochstrom im Hilfsschalter mit Überlagerung eines Schwingstroms als Gegenstrom

Fig. 9: Schwingstrom als Gegenstrom

Fig. 10: Hochstrom im Prüfschalter

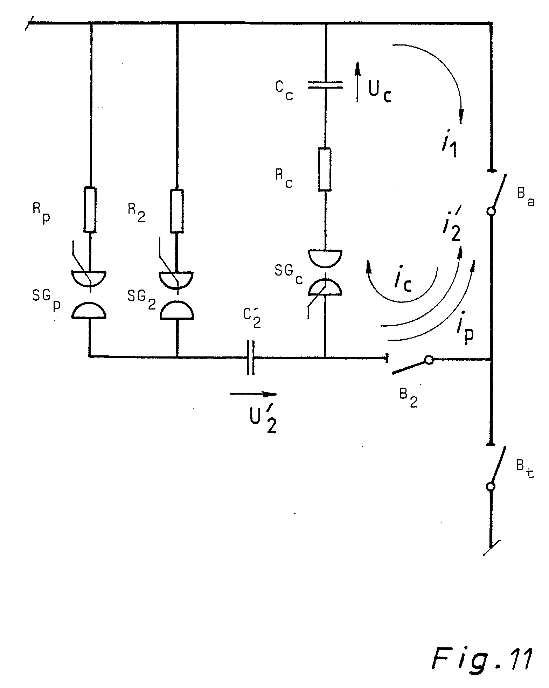

Fig. 11: Schaltplan eines Gegenstromkreises für aperiodischen Gegenstrom einschließlich Strom-Null-Erzeugungs-stromkreis für den Hilfsschalter $B_2$

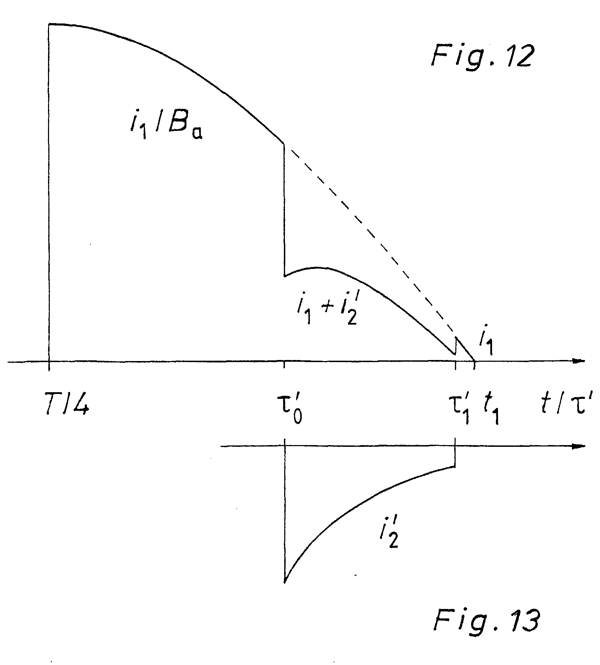

Fig. 12: Hochstrom im Hilfsschalter mit Überlagerung eines aperiodischen Stroms als Gegenstrom

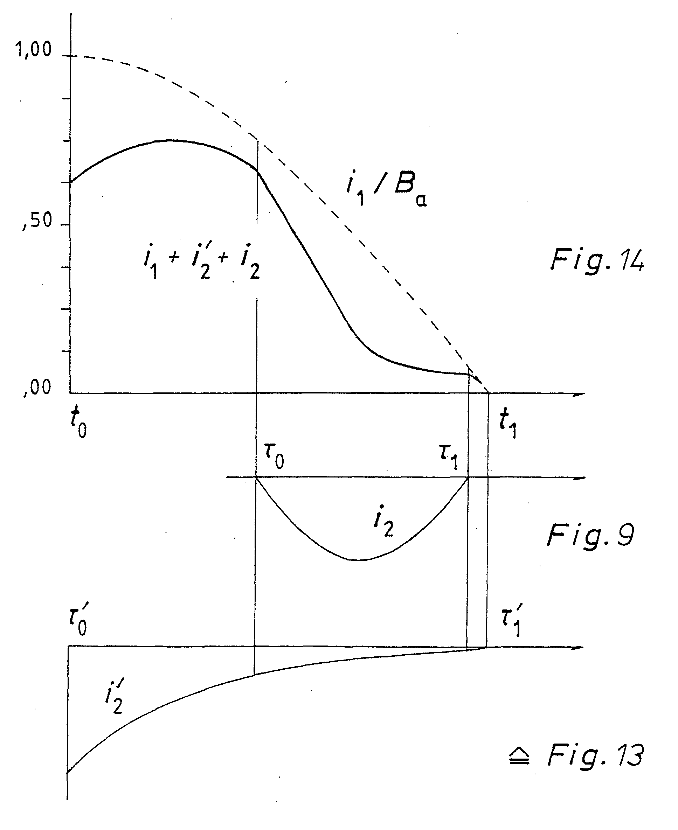

Fig. 13: Gegenstrom, exponentiell abklingend

Fig. 14: Hochstrom im Hilfsschalter, Überlagerungen: eines aperiodischen Gegenstroms mit relativ zu Fig. 13 größerer Zeitkonstante und eines periodischen Gegenstroms nach Fig. 9

Den Hochstromkreis I im Schaltplan der synthetischen Prüfschaltung, Fig. 1, bilden im wesentlichen die folgenden Bauelemente:

- Hochstromgenerator G mit der betriebsfrequenten Klemmenspannnug $U_1$

- Induktivität $L_1$, gegebenenfalls die Induktivitäten eines nicht dargestellten Transformators und einer Spule zum Einstellen bestimmter Hochstromwerte enthaltend

- Sicherheitsschalter (master circuit-breaker) MB und Draufschalter (making switch) MS, beide Schalter in einem Schaltapparat zusammengefaßt

- Hilfsschalter (auxiliary circuit-breaker) AB und Prüfschalter (test circiut-breaker) TB

- Kapazität (capacitance) $C_1$ zum Einstellen einer bestimmten Frequenz der Einschwingspannung des Hochstromkreises

Bei erfindungsgemäß thermischer Äquivalenz der zugrunde liegenden synthetischen Prüfschaltung kann ohne Bedenken den Wechselstromgenerator G mit der subtransienten Kurzschlußinduktivität $L_1$ und dem Scheitelwert $\hat{U}_1$ der Klemmenspannung $U_1$ ein $L_oC_o$-Kreis mit möglichst geringer Dämpfung ersetzen. Die Kreisfrequenz dieses Schwingkreises,

$$v_o = (L_oC_o)^{-0,5},$$

ist auf die Kreisfrequenz $\omega$ des Generators abgestimmt und die Kapazität $C_o$ ist auf die Gleichspannung $\hat{U}_1$ aufgeladen.
Unter dieser Voraussetzung bietet der Schwingkreis als Hochstromkreis in synthetischen Prüfanlagen für die Prüfung von Mittelspannungs-Wechselstrom-Leistungsschalter Vorteile.
Den Hochspannungskreis II dieser synthetischen Prüfschaltung bilden im wesentlichen die Bauelemente:

- Hochspannungskapazität $C_h$, aufladbar auf eine hohe Gleichspannung $U_h$

- Hochspannungsinduktivität $L_h$

- Hochspannungsdämpfungswiderstand $R_h$

- Hochspannungskapazität $C_a$, parallelgeschaltet dem Hilfsschalter AB

Spezielle Bauelemente werden in der Beschreibung der zugehörigrn Ausführungsbeispiele genannt und in der Funktion erläutert.
Bei geschlossenem Sicherheitsschalter schließt der Draufschalter den Hochstromkreis, z.B. im Spannungsmaximum, falls ein symmetrischer Hochstrom fließen soll. Hilfs- und Prüfschalter ha-Ausschaltkommandos (opening command) erhalten; z.B. sind diese Kommandos so gestaffelt, daß sich die Kontakte des Hilfsschalters erst im Verlauf der letzten Halbschwingung des zu unterbrechenden Stroms trennen.

Außerdem erfolgt das Auslösen (tripping) von Hilfs- und Prüfschalter abgestimmt auf die Polarität der letzten Halbschwingung des Hochstroms mit anschließender Einschwingspannung des Hochstromkreises und auf die Polarität der Spannung $U_h$ an der Kapazität $C_h$ des Hochspannungskreises in der Weise, daß sich diese Spannungen in der synthetischen Prüfschaltung addieren.

Dem Hilfsschalter ist eine Schaltvorrichtung - ausgeführt als Halbleiter-Gleichrichterdiode DI - parallelgeschaltet, im Ausführungsbeispiel in Durchlaßrichtung für eine mit positiver Polarität wiederkehrende Spannung des Hochstromkreises; die zu einem späteren Zeitpunkt an der Parallelkapazität $C_a$ entstehende Spannung des Hochspannungskreises wird diese Diode in Sperrrichtung beanspruchen.

Als Dioden stehen Halbleiter-Gleichrichterzellen zur Verfügung auf der Basis von Selen, Germanium, Silizium.

Den geringsten Widerstand haben Silizium-Leistungsdioden; die Sperrspannung beträgt 4 bis 5 kV. Die Spannung, von der ab die Diode stromführend wird, Schwellspannung (threshold voltage) genannt, beträgt 0,4 bis 0,5 V bei Betriebstemperatur von etwa 140°; diese Temperatur läßt sich bei Verwendung in der Prüfschaltung durch äußere Wärmezufuhr erzeugen, z.B. durch einen Infrarotstrahler. Up-to-date Kennwerte enthalten die Datenblätter von Herstellerfirmen.

Den Verlauf einer Einschwingspannung am erstlöschenden Pol eines 12 kV Leistungsschalters, Maximalwert rd. 21 kV, zeigt Fig. 4. Daran hat die Einschwingspannung des Hochspannungskreises einen Anteil von 18 kV. Sind dafür bei 4 kV Sperrspannung einer Siliziumzelle und sicherheitshalber angenommenen 20 kV der Teilspannung 5 Zellen vorgesehen, so resultiert eine Schwellspannung $5 \times 0,5 = 2,5$ V. Dieser Spannnugswert wird praktisch verzögerungsfrei erreicht.

Bei hohen Spannungen ist jeweils eine entsprechende Anzahl solcher Halbleiterdioden in einer Trag- und Isolierröhre angeordnet. Den in Reihe geschalteten Gleichrichterelementen sind Mittel zur Spannungssteuerung, z.B. Steuerkapazitäten parallelgeschaltet. Fig. 2 zeigt zwei in Reihe geschaltete Diodenstäbe; gegebenenfalls kann mit den Steuerkapazitäten $C_{D1}$, $C_{D2}$ ein ohmscher Widerstand parallel oder in Reihe oder sowohl als auch geschaltet sein.

An Stelle der Halbleiter-Gleichrichterdiode DI kann auch ein Halbleiter-Vierschicht-Bauelement als Triode geschaltet - "Thyristor" benannt - verwendet werden; in Fig. 1 ist ein Thyristor als Anwendungsvariante gestrichelt eingezeichnet; in Durchlaßrichung angeordnet, muß er noch gezündet werden, was nicht mehr dargestellt ist.

Parallel zum Hilfsschalter ist des weiteren eine Kapazität $C_a$ angeordnet. Zunächst stellt diese Kapazität eine kapazitive Ankopplung (capacitive coupling) mit hohem Ankopplungswirkungsgrad (high coupling efficiency) des Prüfschalters an den Hochstromkreis dar.

Die Kapazität $C_a$ kan auch in Verbindung mit ohmschen Widerständen dem Hilfsschalter parallelgeschaltet sein: der Widerstand ist mit der Kapazität in Reihe oder dieser parallelgeschaltet; oder es sind ohmsche Widerstände der Kapazität $C_a$ sowohl in Reihe als auch parallelgeschaltet.

Allein oder mit der vorstehend beschriebenen Widerstandsbeschaltung kann die Kapazität $C_a$ auch noch zur bereits an früherer Stelle beschriebenen Spannungssteuerung von in Reihe geschalteten Halbleiterdioden aber auch Halbleitertrioden verwendet werden.

Die Schaltfunkenstrecke $SG_h$ im Hochspannungskreis II wird im Bereich des ersten Scheitelwerts der Einschwingspannung des Hochstromkreises I gezündet. Zu diesem Zweck überträgt eine Koppelkapazität $C_c$ einen Spannungsimpuls, der beim Spannungsdurchschlag einer Meßfunkenstrecke MG entsteht, als Zündimpuls an eine Zündelektrode der Schaltfunkenstrecke $SG_h$; in der Anschlußleitung der Meßfunkenstrecke ist ein hochohmiger Widerstand $R_m$ angeordnet. In der Folge erscheint an der Kapazität $C_a$ der Anteil des Hochspannungskreises an der synthetischen Spannung.

Bei einem dielektrischen Versagen des Prüfschalters nach dem Zuschalten des Hochspannungskreises liefert dieser Kreis den Anfangs-Kurzschlußeinschaltstrom (initial transient making current). Durch die Diode parallel zum Hilfsschalter schließt sich der netzfrequente Kurzschlußstrom unmittelbar an. Diese Stromfolge gewährleistet eine sichere Anzeige eines dielektrischen Versagens des Prüfschalters auch bei einem kleinen Wert der Kapazität $C_a$ von z.B. nur 10 nF gemäß IEC Publication 60427, Third edtion, 2000-04, Seite 25.

Vor einer Beschädigung durch einen zu großen Strom schützt die Diode DI z.B. eine kurzschlußstromfeste Funkenstrecke $SG_1$, die den Kurzschlußstrom ableitet; gezündet wird diese Funkenstrecke durch ein Zündgereät ID (ignition device), das ein Stromwandler CT in der Anschlußleitung der Diode aktiviert. An Stelle der Schutzfunkenstrekke oder zusätzlich kann in dieser Anschlußleitung eine Hochleistungssicherung vorgesehen sein.

Das Auslösen von Hilfs- und Prüfschalter sowie der Schaltfunkenstrecke $SG_h$ abgestimmt auf Addition der wiederkehrenden Spannung im Hochstromkreis und der auf Abruf anstehenden Spannung im Hochspannungskreis braucht - erfolgt die Abstimmung von Hand - Zeit und Überlegung; Fehler sind nicht ausgeschlossen. Automatisierung kann helfen.

Dafür bietet sich in der Patentschrift DE 977 136 eine ausführlich erläuterte Vorlage an. Es handelt sich um einen "einzigen Kondensator, dessen Entladung zur Wiederzündung des Lichtbogens (in Hilfs- und Prüfschalter) unabhängig von der zufälligen Polarität der zugehörigen (letzten) Hochstromhalbwelle" eine "Einrichtung (Doppelschaltfunkenstrecke an jeder Anschlußseite der Kondensatorbatterie) vornimmt"; siehe: Patentansprüche 1, 2 und Abb. 3 sowie Beschreibung.

Diese Einrichtung "wird durch eine zusätzliche dem Hochstromkreis entnommene Größe, wie Höhe der Lichtbogenspannung oder Anzahl der Hochstromhalbwellen, ausgelöst.", siehe Patentanspruch 1 und Abb. 3. Es braucht jetzt nur die Kapazität C mit Wechselschalteinrichtung und Steuerung aus dem Schaltplan der Abb. 3 zu prinzipiel gleicher Funktion in den Schaltplan der Fig. 1 transferiert zu werden und ist hier die Kapazität $C_h$.

Im Schaltplan dieser Figur ist dann noch - um speziell "unabhängig von der zufälligen Polarität der zugehörigen Hochstromhalbwelle" zu sein - die Halbleiterdiode DI parallel zum Hilfsschalter AB durch zwei Thyristoren in Antiparallelschaltung zu ersetzen. Die zugehörige Steuerung zündet jeweils denjenigen Thyristor, der für die bei einer Schalterprüfung sich zufällig ergebende Einschwingspannung des Hochstromkreises in Durchlaßrichtung geschaltet ist.

Die wiederkehrende stationäre Spannung der synthetischen Prüfschaltung gemäß Fig. 1 stellt relativ eine Dauerbeanspruchung des Prüfschalters dar durch die Summe der betriebsfrequenten Spannung des Hochstromkreises I und der Gleichspannung des Hochspannungskreises II:

$$u_{TB} = \hat{U}_1 \cdot \cos\omega(t-t_o) + U_h ,$$

$$\hat{U}_1 + U_h = h \cdot \hat{U}_{ph} , \tag{1}$$

siehe auch Fig. 3, stark voll ausgezogener Linienzug. Der "Erstlöschende Polfaktor"(first pole-to-clear factor) hat die Wete 1,3 bzw. 1,5, siehe IEC Publication 60427, Third edition, 2000-04.

Im Drehstromnetz fällt jedoch die Erstlöschende Polspannung nach der Stromunterbrechung in allen drei Schalterpolen auf die Phasenspannung $U_{ph}$ ab. Demnach wird in der synthetischen Prüfschaltung nach Fig. 1 der Prüfschalter im Zeitintervall der Prüfung mit betriebsfrequenter Spannung - Dauer: mindestens 0,1 s, siehe IEC Publication 60427, Third edition, 2000-04, S. 21 - erheblich überbeansprucht, nämlich mit 30% bzw. 50%. Die Lösung dieses Problems stellt sich als Erfindungsaufgabe und sieht wie folgt aus:

Die Kondensatorbatterie mit der Gesamtkapazität $C_h$ und der Spannung $U_h$ daran ist zumindest zweifach unterteilt, siehe Fig. 3, Baugruppe links oben. Eine erste Teilkapazität $C_{h1}$ mit der Teilspannung $U_{h1}$ erhöht den Scheitelwert $\hat{U}_1$ der betriebsfrequenten Spannung des Hochstromkreises I auf den Scheitelwert der Phasenspannung $\hat{U}_{ph}$ :

$$\hat{U}_1 + U_{h1} = \hat{U}_{ph} \tag{2}$$

Eine zweite Teilkapazität $C_{h2}$ mit der Teilspannung $U_{h2}$ erhöht die Phasenspannung auf den Scheitelwert der erstlöschenden Polspannung :

$$\hat{U}_1 + U_{h1} + U_{h2} = h \cdot U_{ph} \tag{3}$$

Im Zeitpunkt des Strom-Null, $t_o$, oder kurze Zeit $\Delta t$ später, wird der Kapazität $C_{h2}$ mittels einer Schalteinrichtung, ausgeführt als Schaltfunkenstrecke SG, eine Impedanz Z, z.B. als ohmscher Widerstand R, parallelgeschaltet. Daraufhin klingt die Spannung $U_{h2}$ aperiodisch gedämpft ab (decays aperiodically damped); siehe Fig. 3, schwach strichpunktierter Funktionsverlauf über t. Den Prüfschalter beansprucht die synthetische Spannung

$$U(t-t_o) = \hat{U}_1 \cos\omega(t-t_o) + U_{h1} + U_{h2} \cdot e^{-\frac{t-t_o}{T}} , \tag{4}$$

$$T = R \times C_{h2},$$

siehe Fig. 3, stark strichpunktierter Funktionsverlauf über Zeitlinie $(t-t_o)$; Endgröße ist die stationäre Spannung nach Gleichung (2).

Das Parallelschalten von R erfolgt unter bestimmten Vorgaben. Der Überschwingfaktor der Einschwingspannung ist durch Empfehlungen der International Electrotechnical Commission für den internationalen Gebrauch gegeben

mit -$\gamma$ = 1,5 bzw. 1,4. Dieses Überschwingen soll durch den parallelgeschalteten ohmschen Widerstand zumindest nicht erheblich verkleinert werden; daraus ergibt sich ein praktischer Zeitpunkt für den Zeitpunkt des Entladens der Teilkapazizät $C_{h2}$: frühestens kurz vor dem Maximalwert dieser Einschwingspannung.

Die Zeitkonstante T, Gleichung (4), soll so gewählt sein, daß die synthetische wiederkehrende Spannung sich dem Verlauf der homogenen, netzfrequenten wiederkehrenden Spannung möglichst gut angleicht: bei 0,27 ms zeitlichem Abstand vom Scheitelwert der Bezugsspannung, siehe stark strichdoppelpunktierten Spannungsverlauf über der Zeitlinie t in Fig. 3, beträgt der Unterschied zu dieser Spannung minus 0,6 %; der zweite Scheitelwert der stationären synthetischen Spannung überschreitet den Scheitelwert der netzfrequenten Phasenspannung als wiederkehrende Spannung geringfügig um plus 7 %.

Auch der Anteil der betriebsfrequenten Wechselspannung an der synthetisch wiederkehrenden Spannung nimmt zu; bei einem synthetischen Verstärkungsfaktor von 5 z.B. um rund 40 %; dies bedeutet eine weitere erhebliche Verbesserung, hier; der post-TRV-Äquivalenz der zu Grunde liegenden synthetischen Prüfschaltung.

Eine noch bessere synthetische Nachbildung der netzfrequenten wiederkehrenden Spannung ergibt sich, wenn das Entladen der Teilkapazität $C_{h2}$ der Kondensatorbatterie $C_h$ in zwei Stufen erfolgt: zu einem späteren Zeitpunkt wird dieser Teilkapazität mittels einer zweiten Schaltfunkenstrecke noch ein zweiter Entladewiderstand parallelgeschaltet - nicht mehr bildlich dargestellt.

Nun wird noch ein anderes Verfahren beschrieben, die wiederkehrende stationäre Spannung an den Klemmen des erstlöschenden Schalterpols eines dreipoligen Schalters bei der Unterbrechung eines dreiphasigen Kurzschlußstroms im Drehstromnetz in der synthetischen Prüfschaltung für den Prüfschalter nachzubilden.

Im Hochspannungsteil II der synthetischen Prüfschaltung wird ein zweiter, zunächst offener Schwingkreis gebildet mit zumindest näherungsweise der Betriebsfrequenz des Hochstromkreises I. Dafür ist der Kapazität $C_h$ eine entsprechend bemessene Induktivität $L_p$ in Reihe geschaltet, Dieser Schwingkreis wird frühestens im Zeitpunkt des letzten Strom-Null des Hochstroms im Prüfschalter geschlossen durch eine Schalteinrichtung, z.B. eine Schaltfunkenstrecke $SG_p$ mit Stromunterbrechungsvermögen, gesteuert gezündet mittels Steuer-Stromwandler CT und Zündgerät ID, Fig. 1.

Der betriebsfrequente Schwingstrom (nicht dargestellt) wird nach einer Halbschwingung unterbrochen; während dieses Zeitintervalls polt sich die Spannung $U_h$ an der Kapazität $C_h$ um, zu mindest näherungsweise synchron mit der betriebsfrequenten Spannung $u_1$ ($t-t_o$) des Hochstromkreises.

Die Dämpfung des Spannungsumpolungsschwingkreises (voltage polarity reversing oscillating circuit) durch einen ohmschen Widerstand $R_p$ :

$$\delta = \frac{2\,R_p}{L_p} \tag{5}$$

ist so bemessen, daß dabei die Spannung $U_h$ auf einen Wert abklingt, der den Scheitelwert der wiederkehrenden stationären Spannung des Hochstromkreises auf den Scheitelwert der Phasenspannung erhöht:

$$\hat{U}_1 + (u_h)\,\vartheta = \frac{\pi}{\nu} = \hat{U}_{ph} \tag{6}$$

Die Kreisfrequenz $\nu_p$ der gedämpften Umpolungsschwingung

$$\frac{\nu_p}{\nu_{po}} \approx 1 - \frac{R_p^2\,C_p}{8\,L_p} \quad , \tag{7}$$

$$\nu_{po}^2 = (L_p C_h)^{-0,5} \quad ,$$

beträgt im Ausführungsbeispiel rund 98 % von $\nu_{po}$ und gleicht wegen $\nu_{po} = \omega$ praktisch der Betriebskreisfrequenz des Hochstromkreises.

Die erfindungsgemäß gedämpfte Umpolungsschwingung der Spannung $U_h$ des Hochspannungskreises:

$$u_h \approx U_h \, e^{-\delta\vartheta} \cos \nu_p \, \vartheta \qquad\qquad (8)$$

ist entlang der Zeitachse $\vartheta$, Fig. 3, schwach strichdoppelpunktiert eingezeichnet; wie dort auch zu sehen ist, bleibt diese Spannung nach der Umpolung als Gleichspannung an der Kapazität $C_h$ liegen.

Der Verlauf der Summenspannung aus der Umpolungsspannung des Hochspannungskreises, Glg. (8), und der betriebsfrequenten Spannung des Hochstromkreises, Glg. $u_1$ ist entlang der Zeitachse t stark strichdoppelpunktiert dargestellt; nach der Unterbrechung des nicht dargestellten Umpolungsstroms durch die Schaltfunkenstrecke $SG_B$ wird die wiederkehrende synthetische Spannung durch die Wechselspannung $u_1(t-(t_o+T_p/2))$ mit Gleichspannungsglied

$$(u_h) \; \vartheta = \frac{\pi}{\nu} = T_p/2$$

gebildet.

Im Zeitintervall ca 10 ms nach der Stromunterbrechung besteht praktisch Äquivalenz der synthetischen Spannungsbeanspruchung des Prüfschalters mit dessen Spannungsbeanspruchung als erstlöschender Schalterpol in einem Drehstromnetz.

Entsprechend der oszillierenden Umpolung der Spannung $U_h$ an der Kapazität $C_h$ des Hochspannungskreises ist an Stelle der Halbleiterdiode DI in Fig. 1 parallel zum Hilfsschalter AB ein Thyristor vorzusehen, gestrichelt als Austauschbauelement eingezeichnet; bei in Durchlaßrichtung anstehender Wechselspannung $u_1$ des Hochstromkreises muß diese Triode durch einen Zündstrom gezündet werden; für die nachfolgenden Halbschwingungen dieser Spannung mit Durchlaßpolarität bleibt sie ungezündet und und verhält sich praktisch wie ein offener Schalter.

Als Koppelelement zwischen Hochstromkreis und Prüfschalter dient dann die Kapazität $C_a$ parallel zum Hilfsschalter. Dabei ist der Kapazität $C_a$ die Kapazität $C_h$ mit der Spannung $U_h$ durch die Schaltfunkenstrecke $SG_h$ wie eine Pufferbatterie (back-up battery) parallelgeschaltet.

Alternativ zur ursprünglichen Schaltung kann in Reihenschaltung mit der dem Hilfsschalter parallelgeschalteten Diode ein steuerbarer Trennschalter (controllable isolating switch) angeordnet sein. Im Ablaufprogramm für die synthetische Prüfschaltung öffnet dieser zunächst geschlossene Schalter spätestens im Spannungsnulldurchgang der Umpolungsschwingung der Spannung $U_h$ an der Kapazität $C_h$, siehe Fig. 3, schwach strichdoppelpunktierter Spannungsverlauf. Zur Erleichterung der Steuerung des Trennschalters kann die Umpolungsfrequenz ohne Nachteil für das grundsätzliche Verfahren relativ zur Betriebsfrequenz des Hochstromkreises etwas verkleinert werden.

Die natürliche Einschwingspannung eines Hochstromkreises weist hohe Überschwingfaktoren (amplitude factor) auf von $\gamma = 1,8$ bis $\gamma = 1,9$. Wird diesem Spannungsverlauf mit derart großen Ausschwingungen etwa ab dem ersten Scheitelwert eine nahezu linear ansteigende Spannung überlagert, so ergibt das einen erheblich verzerrten Verlauf der Summenspannung. Eine vorgebene Grenzlinie kann gekreuzt werden und die Prüfung ist dann ungültig, siehe Fig. 4 sowie IEC Publication 60056 und DIN VDE 0670, Teil 104, Oktober 1992, Seite 42, Bild 2B, 24, Seite 42, Bild 25, 26.

Um dies zuvermeiden, ist es üblich, den Anteil des Hochspannungskreises an der Einschwingspannung stark zu dämpfen, gekennzeichnet durch einen Überschwingfaktor von etwa 1,3, siehe IEC Publication 60427, Third edition, 2000-04, Seite 105, Fig. CC.2, $u_1$.

Damit verbindet sich jedoch ein steiles Ansteigen der Einschwingspannung des Hochstromkreises und folglich eine durch Prüfungsrichtlinien nicht verlangte Überbeanspruchung des Prüfschalters. Als Erfindungsaufgabe ergibt sich daraus:

- den Vorteil einer schwach gedämpften Einschwingspannung des Hochstromkreises nutzen

- die schädliche Auswirkung bei der Spannungsüberlagerung durch schaltungstechnische Maßnahmen vermeiden

Eine Methode, dieses Problem zu lösen,sieht wie folgt aus:

Eine Glättungskapazität $C_s$ (smoothing capacitance) ist aufgeladen (charged) auf eine Gleichspannung $U_s$ (direct voltage) von etwa a gleicher Höhe und gleicher Polarität wie die erste Amplitude der Einschwingspannung $u_1(t)$ des Hochstromkreises an der Kapazität $C_1$, siehe Fig. 1 und 4. Diese Glättungskapazität wird mittels einer Meß- und Schalteinrichtung - ausgeführt in Form einer Meß- und Schaltfunkenstrecke MSG (measuring and switching gap arrangement) z.B. als eine Drei-Elektrodenfunkenstrecke - der Kapazität $C_1$ parallelgeschaltet, sobald die Spannung daran die genannte Höhe erreicht hat.

Zunächst zündet die Meßfunkenstrecke mit den Elektroden Z, X. Die Mittelelektrode Z ist über einen hoch-

ohmigen Widerstand $R_m$ und eine diesem Widerstand parallelgeschaltete relativ kleine Kapazität $C_m$ mit Null-Potential verbunden; daher führt sie bei einem Spannungsüberschlag kurzzeitig Null-Potential und bewirkt auch den Spannungsüberschlag an der Schaltfunkenstrecke mit den Elektroden Z, Y; damit ist die Spannung führende Glättungskapazität $C_s$ an den Hochstromkreis parallel zur Kapazität $C_1$ geschaltet worden; in der Verbindungsleitung zum Hochstromkreis befindet sich ein Dämpfungswiderstand $R_d$.

Die resultierende Kapazität $(C_1+C_s)$ verkleinert die Frequenz der Einschwingspannung des Hochstromkreises und glättet so diese Spannung relativ zur überlagerten Spannung des Hochspannungskreises. Der Erfolg: die synthetische Spannung an den Klemmen des Prüfschalters verläuft innerhalb der gesetzten Grenzlinien, siehe Fig. 4:

$$u_T = u_1'(t-t_1) )_{t: \text{ bis } t_2} ,$$

anschließend:

$$u_T = u_1'(t-t_2) + u_h(t-t_2) . \tag{9}$$

Die Elektroden Z, X der Drei-Elektrodenfunkenstrecke MSG, Fig. 5, können auch als Bauelemente der Steuerung der synthetischen Prüfschaltung in Fig. 1 verwendet werden, falls die vorstehend beschriebene Methode der Spannungsglättung dort eingesetzt wird. Der Spannungsimpuls beim Überschlag der Meßfunkenstrecke wird über die Koppelkapazität $C_c$ - oder auch über eine spezielle, nicht dargestellte Zündeinrichtung - an die Zündelektrode der Schaltfunkenstrecke $SG_h$ übertragen und setzt den Hochspannungskreis in Betrieb.

Bei einem Betrieb der synthetischen Prüfschaltung mit automatisch polaritätsrichtiger Reihenschaltung des Hochstrom- und Hochspannungskreises wird auch die Spannungsglättungseinrichtung automatisch polaritätsrichtig mit dem Hochstromkreis verbunden; dies erfolgt analog zum polaritätsrichtigen Anschalten der Kapazität $C_h$ des Hochspannungskreises, was schon erläutert wurde.

Alternativ bietet sich hier noch ein einfacheres Verfahren an: Je eine Spannungsglättungseinrichtung nach Fig. 5 wird auf eine Spannung positiver bzw. negativer Polarität aufgeladen. Eine Steuerung schaltet jeweils die bezüglich der Polarität ihrer Spannung richtige Glättungseinrichtung an den in Betrieb befindlichen Hochstromkreis.

Den Verlauf der synthetischen Einschwingspannung durch Reduzieren der Frequenz der Einschwingspannung des Hochstromkreises zu glätten, läßt sich auch noch nach einer anderen, nachfolgend erläuterten Methode realisieren.

In der Stromleitung von der Hochstromenergiequelle G, oder auch $C_o$, bis zur Anschlußstelle der Kapazität $C_1$ sind ein Hilfsschalter $AB_1$ und eine diesem Schalter parallelgeschaltete Halbleiterdiode $DI_1$ installiert, Fig. 6. Nach dem letzten Strom-Null des Lichtbogenstroms in den Leistungsschaltern $AB_1$, AB, TB schwingt an der natürlichen Kapazität $C_e$ und an der Justierkapazität $C_1$ des Hochstromkreises die nur natürlich gedämpfte wiederkehrende Spannung dieses Stromkreises ein.

An der Kapazität $C_1$ ist dieses Einschwingen (oscillating set in) der Spannung bei dafür in Durchlaßrichtung geschalteter Diode mit dem Erreichen des ersten Scheitelwerts beendet; eine Triode, Thyristor, müßte durch eine Steuerung noch gezündet werden. Dieser Maximalwert der Einschwingspannung bleibt als Gleichspannung an der Kapazität $C_1$ liegen. Außerdem sind im Schaltplan die bereits an früherer Stelle erläuterten Bauelemente $R_m$ , MG, $C_c$ zur Steuerung des Hochspannungskreises eingezeichnet. Nach dem Zünden der Schaltfunkenstrecke $SG_h$ verläuft die transiente Klemmenspannung (terminal voltage) des Prüfschalters wie:

$$u_T = u_1(t-t_1)_{t: \text{ bis } t_2} , \tag{10}$$

anschließend:

$$u_T = \gamma \hat{U}_1 + u_h'(t-t_2) ,$$

siehe Fig. 4.

Die wiederkehrende stationäre Klemmenspannung am Prüfschalter stellt sich dar als Summe von zwei Gleich-spannungen, des Hochstromkreises:

$$U_1(t)_{t=t_2} = \gamma \, \hat{U}_1 \qquad (11)$$

und des Hochspannungskreises:

$$U_h' = U_h - (\gamma - 1).\hat{U}_1 \;, \qquad (12)$$

zu:

$$u_T(t)_{t \to \infty} = \gamma \, \hat{U}_1 + U_h' = \hat{U}_1 + U_h \qquad (13)$$

Die Gleichung (12) offenbart den Vorteil, an Ladespannung bei der Kapazität $C_h$ sparen zu können; der Relativbetrag der Spannungseinsparung errechnet sich nach der Formel:

$$\frac{U_h - U_h'}{U_h} = \frac{\gamma - 1}{a - 1} \; ; \qquad (14)$$

mit z.B. einem Überschwingfaktor $\gamma = 1,9$ und einem Verstärkungsfaktor a = 5 beträgt die relative Einsparung 22,5 %.

Falls die vorstehend erläuterte Methode der Spannungsglättung in der synthetischen Prüfschaltung nach Fig. 1, jedoch mit automatisch polaritätsrichtiger Reihenschaltung der Spannungen an den Kapazitäten $C_1$ und $C_a$ des Hochstrom- bzw. Hochspannungskreises, angewendet werden soll, wird dem Hilfsschalter $AB_1$ statt der Halbleiterdiode eine Antiparallelschaltung von zwei Halbleitertrioden (Thyristoren) parallelgeschaltet; gezündet wird dann jeweils derjenige Thyristor, der bezüglich der zufälligen Polarität der Einschwingspannung des Hochstromkreises in Durchlaßrichtung geschaltet ist.

Laut IEC Publication 60427, Third edition 2000-04, Seite 25 "the auxiliary circuit-breaker should have an arc voltage less or equal to that of the test circuit-breaker." Eine Information, wie die Lichtbogenspannung des Hilfsschalters verkleinert werden kann, wird nicht gegeben.

Es ist bekannt, zu diesem Zweck als Hilfsschalter Vakuumschalter zu verwenden mit relativ zu Druckgasschaltern kleinerer Lichtbogenspannung pro Unterbrechereinheit. Im Bereich der Hochspannung müssen jedoch für große Ausschaltströme etwa gleich oder größer 40 kA Unterbrechereinheiten von Vakuumschaltern in Reihe geschaltet werden, sodaß sich in Summe die Lichtbogenspannung wieder erhöht. Und z.B. mit einem Vakuumschalter als Prüfschalter ist die Lichtbogenspannung wieder in etwa gleich groß.

Geht es in der vorgenannten IEC-Empfehlung aber darum, mit einer kleineren Lichtbogenspannung des Hilfsschalters seine Unterbrecherwirkung zu reduzieren, um die Nachleitfähigkeit im Zeitbereich der Wechselwirkung zwischen Hochstromkreis und Prüfschalter zu erhöhen - siehe IEC Publication 60427, Third edition 2000-04, Seite 25 und Seite 49, Fig. 1 - so sollte auch die thermische Beanspruchung des Hilfsschalter in geeigneter Weise reduziert werden.

Eine Reduktion der thermischen Beanspruchung des Hilfsschalters dadurch, daß sich dem Hochstrom ein Schwingstrom entgegengesetzter Polarität überlagert - in einem dem Hilfsschalter parallelgeschaltetem Hochspannungsschwingkreis - ist bekannt als systemtypisches Merkmal einer synthetischen Prüfcschaltung - siehe IEC Publication 60427, Third edition 2000-04, Seite 97, Figuren BB3 und BB4.

Dieser Schwingstrom soll - mit veränderten Parametern - als Folgestrom den Hochstrom kurz vor dessen Strom-Null nachbilden; dadurch ist er bezüglich Amplitude, Frequenz und Phasenlage bereits bestimmt und somit nicht mehr verfügbar zur freien Optimierung als Kompensationsstrom im Hilfsschalter.

Aus der vorstehenden Analyse des relevanten Standes der Technik ergibt sich als Erfindungsaufgabe: autonome Reduktion der thermischen Beanspruchung des Hilfsschalters durch die thermische Energie des Ausschaltstrom-Lichtbogens. Diese Erfindungsaufgabe wird durch die Nebenansprüche 6 und 9 gelöst; vorteilhafte Weiterbildungen sind in den zugehörigen Unteransprüchen beschrieben.

Das Wesentliche und Vorteilhafte dieser Erfindungen besteht in: Reduktion der Energie des Hochstromlichtbogens im Hilfsschalter als Voraussetzung einer reduzierten Löschmitteleinwirkung und in Folge einer erhöhten Nachleitfähigkeit dieses Schalters zur Verbesserung der Äquivalenz der thermischen Beanspruchung des Prüfschalters in dieser synthetischen Prüfschaltung mit dessen Beanspruchung in einer direkten Prüfschaltung und dies wahlweise durch:

-     Kontakttrennung des Hilfsschalters erst im Bereich der Hochstromamplitude bei ausgewogener Abstimmung zwischen dem Ausmaß der Verkleinerung der Lichtbogenenergie einerseits und dem Mehraufwand für ererhöhte Kontaktgeschwindigkeit andererseits, oder

- Überlagern eines Stroms mit entgegengesetzter Polarität in einem unabhängigen, dem Hilfsschalter vor dem letzten Strom-Null parallelzuschaltendem Stromkreis, oder

- Kombination dieser beiden Maßnahmen in der vorstehenden Reihenfolge und in weiterer Konsequenz

- Einsparen des Transformators im Hochstromkreis

- für die Prüfung zumindest von Mittelspannungs-Leistungsschaltern kann ein Hochstromgenerator mit Klemmenspannung gleich oder kleiner 1 kV verwendet werden

Den Hochstromkreis im Schaltplan der synthetischen Prüfschaltung, Fig. 7, bilden im wesentlichen ein Generator G als Wechselstromquelle, Klemmenspannung $U_1$, mit oder ohne nachgeschaltetem Transformator, resultierende Induktivität $L_1$, gegebenenfalls noch eine zusätzliche Strombegrenzungsinduktivität mitrepräsentierend, ein Sicherheitsschalter MB und ein Draufschalter MS, beide Schalter zu einem Apparat zusammengefaßt, ein Hilfsschalter $B_a$, ein Prüfschalter $B_t$, eine Kapazität $C_1$ die natürliche und eventuell noch eine zusätzliche Kapazität darstellend sowie ein ohmscher Widerstand $R_1$, z.B. der Kapazität $C_1$ parallelgeschaltet.

Den Hochspannungsschwingkreis bilden im wesentlichen eine Kapazität $C_h$, aufladbar auf eine hohe Gleichspannung $U_h$, als Hochspannungsquelle, eine Induktivität $L_h$, eine Kapazität $C_a$ dem Hilfsschalter $B_a$ parallelgeschaltet, ein ohmscher Widerderstand $R_h$, z.B. der Induktivität $L_h$ parallelgeschaltet, sowie eine Schaltfunkenstrecke $SG_h$.

Außerdem enhält der Hochstromkreis einen Gegenstromkreis, der dem Hilfsschalter $B_a$ parallelgeschaltet ist und sich im wesentlichen aus folgenden Bauelementen zusammensetzt:

Kapazität $C_2$ aufladbar auf eine Gleichspannung $U_2$, Induktivität $L_2$, steuerbare Schnellschalteinrichtung HSD.

Eine Schalterprüfung läuft wie folgt ab: Bei geschlossenen Sicherheits- und Draufschalter und öffnenden Hilfs- und Prüfschalter erscheint nach dem Strom-Null des Lichtbogen-Hochstroms in diesen beiden Schaltern, $i_1/B_a$ und $i_1/B_t$, mit bereits vorhandener Stromunterbrechungswahrscheinlichkeit die transient wiederkehrende Spannung des Hochstromkreises, $u_1$, an den Klemmen des Generators und damit auch an der Kapazität $C_1$.

Diese Spannung liegt wegen der sehr großen Parallelkapazität $C_a$ des Hilfsschalters relativ zur nicht dargestellten Eigen- oder Steuerkapazität des Prüfschalters praktisch vollständig an den offenen Kontakten des Prüfschalters - als erster Teil einer durch nationale und internationale Bestimmungen vorgegebenen Einschwingspannung.

Kurz vor dem Scheitelwert der Spannung $u_1$ erfolgt ein Überschlag an der Meß- und Steuerfunkenstrecke MG mit dem ohmschen Vorwiderstand R, was einen Spannungsimpuls erzeugt. Dieser Impuls wird durch die Koppelkapazität $C_c$ an eine Triggerfunkenstrecke an der Schaltfunkenstrecke $SG_h$ übertragen und läßt diese Funkenstrecke zünden. In dem jetzt geschlossenen Hochspannungsschwingkreis entsteht an der Kapazität $C_a$ eine transiente Spannung $u_h$ als zweiter Teil der resultierenden Einschwingspannung, $u = u_1 + u_h$, am Prüfschalter.

Diese drei Einschwingspannungen, die zur Erläuterung der Erfindungsgegenstände nicht benötigt werden, sind bereits im zitierten Stand der Technik deutlich dargestellt: DE 1 180 841, Fig. 2 und IEC Publication 60427, Third edition 2000-04, Seite 105, Fig. CC.2.

Nun zur Funktion des Gegenstromkreises im Schaltplan nach Fig. 7 : Vor dem letzten Strom-Null des Hochstroms $i_1$ wird der Schwingkreis im Zeitpunkt $\tau_o$ , Fig. 8, durch die Schnellschalteinrichtung HSD geschlossen. Daraufhin überlagert sich der Halbschwingung des Hochstroms eine Halbschwingung des Schwingstroms $i_2$ mit entgegengesetzter Polarität und zumindest annähernd derselben Stromsteilheit resultierend aus höherer Frequenz und im Frequenzverhältnis verkleinerter Amplitude.

Im folgenden Strom-Null wird der Schwingstrom unterbrochen, Zeitpunkt $\tau_o$ , noch vor dem Strom-Null des Hochstroms, Zeitpunkt $t_1$, und spätestens auch zu diesem Zeitpunkt, Fig. 8, 9.

Diese Abstimmung von Hochstrom und Schwingstrom ergibt im Deckungsbereich der annähernd linearen Stromverläufe einen Stromverlauf mit nahezu gleichbleibender Höhe, Fig. 8.

Diese Stromhöhe läßt sich durch Annähern des Schwingstrom-Nulls an das Strom-Null des Hochstroms weiter verkleinern. Die Anfangsspannung $U_2$ an der Kapazität $C_2$ braucht nur deutlich höher zu sein als die durch den Stromreduktionseffekt bereits verkleinerte Lichtbogenspannung des Hilfsschalters $B_a$. Nach der Unterbrechung des Schwingstroms $i_2$ erfährt die Schnellschalteinrichtung eine spannungslose Pause bis zur Aktivierung des Hochspannungsschwingkreises im Bereich der Amplitude der Teil-Einschwingspannung $u_1$.

Die Schnellschalteinrichtung HSD ist als Vakuumschalter mit feststehenden Kontakten A und B ausgebildet.

Den stromleitenden Zustand der Schaltstrecke dazwischen initiiert ein Zündspannungsimpuls ausgehend von einer Hilfselektrode C, z.B. an der Kontaktelektrode A konzentrisch angeordnet. Den Spannungsimpuls erzeugt ein Steuergerät CD, das z.B. an einen Stromwandler CT angeschlossen ist.

Um die thermische Beanspruchung des Hilfsschalters durch den Lichtbogen des Ausschaltstroms zu verkleinern, kann diesem Strom auch ein aperiodischer Strom mit entgegengesetzter Polarität überlagert werden. Dabei wird nach dem Schaltplan in Fig. 11 wie folgt verfahren: Spätestens bei Kontakttrennung des Hilfsschalters $B_a$ schließt die durch ein nicht dargestelltes Steuergerät gezündete Schaltfunkenstrecke $SG_p$ einen von dem ohmschen Wiederstand $R_p$ und den Schaltern $B_2$, $B_a$ gebildeten Stromkreis; Stromquelle ist darin die Kapazität $C_2'$, die auf eine Spannung $U_2'$ aufgeladen wurde.

Es fließt zuerst ein kleiner -------------------- Vorstrom $i_p$ durch die Schalter $B_2$ und $B_a$ . Bei Kontakttrennung des Schalters $B_2$ geht dieser Strom in einen Lichtbogenstrom über, der die Schaltstrecke leitend hält.

Im Zeitpunkt $\tau$ wird die Schaltfunkenstrecke $SG_2$ durch das Steuergerät CD, Fig. 7, gezündet und der durch den ohmschen Widerstand $R_2$ begrenzte aperiodische Überlagerungsstrom $i_2'$ eingeleitet, Fig. 13.

Der Einfluß verteilter Leitungsinduktivität auf die Stromverläufe $i_2'$ und $i_1+i_2'$), Fig. 12, wurde vernachlässigt. Um gegebenen falls eine weiterentwickelte Form des aperiodischen Stromverlaufs zu erhalten, kann im Gegenstromkreis noch eine - nicht dargestellte - konzentrierte Induktivität angeordnet werden; wegen diesbezüglicher Berchnungsformeln und Stromgraphen siehe: Slamecka/Waterschek "Schaltvorgänge in Hôch- und Niederspannungsnetzen", Verlag Siemens AG 1972, Seiten 272,273.

Zur Unterbrechung des Gegenstroms $i_2'$ wird zum Unterbrechungszeitpunkt $\tau_1'$ die Schaltfunkenstrecke $SG_c$ gezündet. Dazu kann auch das Steuergerät CD verwendet werden, indem es einen zweiten Zündspannungsimpuls erzeugt, der um die Zeit ($\tau_1' - \tau_p'$) verzögert an die Zündelektrode dersvorgenannten Schaltfunkenstrekke geleitet wird. Im jetzt geschlossenen Stromkreis mit der Kapazität $C_c$ - auf eine Gleichspannung $U_c$ aufgeladen - und dem ohmschen Widerstand $R_c$ fließt ein Strom $i_c$, Fig. 5, durch den Schalter $B_2$ und reduziert diesen Gegenstrom auf Null, sodaß er unterbrochen werden kann. als Reduktionsstrom kann auch ein oszillierender Strom in einem höherfrequenten Schwingkreis verwendet werden.

Hinweis zu den Schaltplänen der Figuren 7 und 11: die Schnellschalteinrichtung HSD, Fig. 7, ist gegen die Reihenschaltung aus der Schaltfunkenstrecke $SG_2$ und dem Schalter $B_2$, Fig. 11, als Alternative austauschbar - und umgekehrt.

Für eine besonders wirkungsvolle Gegenstromüberlagerung können sowohl der aperiodische Gegenstromkreis, Fig. 11, als auch der periodische Gegenstromkreis, Fig. 7, in dieser Reihenfolge z.B., dem Hilfsschalter $B_a$ zur Stromentlastung parallelgeschaltet sein, wobei sich die beiden Gegenströme überlappen. Das Ergebnis dieser Zweifach-Gegenstromüberlagerung des Hochstroms im Hilfsschalter $B_a$ zeigt Fig. 14.

Die Kontakte des Hilfsschalters trennen sich im Zeitpunkt $t_0$ der Hochstromamplitude $I_1$. Gleichzeitig wird der aperiodische Gegenstrom $i_2'$ überlagert. Mit einem Anfangswert von 37,5 % der Hochstromamplitude reduziert er diese im Verlauf auf rund 75 %. Der periodische Gegenstrom $i_2$ folgt mit 25 % der Hochstromamplitude und einer Frequenz von 200 Hz zu einem solchen Zeitpunkt $\tau_0$ , daß sein Strom-Null kurz vor dem Strom-Null des Hochstroms liegt, wobei vorher der resultierende Strom nahezu konstant verläuft mit einer Stromhöhe von rund 6 % der Hochstromamplitude.

Eine anderes autonomes Verfahren, den Hilfsschalter $B_a$ thermisch zu entlasten, stellt sich wie folgt dar:

Es ist allgemein nützlich, den Hilfsschalter $B_a$ zeitlich so auszulösen, daß die Dauer des Ausschaltstromlichtbogens in der Schaltstrecke kürzer ist als die Dauer der letzten Teilschwingung des Hochstroms.

Und beim Öffnen der Kontakte des Hilfsschalters im Scheitel einer letzten Halbschwingung des Hochstroms halbiert sich die den Schalter beanspruchende thermische Energie des Ausschaltstromlichtbogens - wie es die Integrale über die Produkte aus Lichtbogenstrom und konstant angenommener Lichtbogenspannung für die verschiedenen Integrationszeitabschnitte zeigen.

Damit in der verbleibenden Zeit bis zum letzten Strom-Null des Hochstroms die Kontakte des Hilfsschalters die Isolierdistanz für die Einschwingspannung ereichen, muß jedoch die Kontaktgeschwindigkeit erhöht werden.

Die den vorstehend dargelegten Maßnahmen am Hilfsschalter $B_a$ innewohnende Gegenläufigkeit - einerseits Verkleinern der Emission thermischer Energie durch den Lichtbogenstrom durch relativ verzögerte Kontakttrennung und andererseits Erhöhen der Kontaktgeschwindigkeit verbunden mit erhöhtem Aufwand für den Schalterantrieb - läßt ein technisch-wirtschaftliches Optimum erwarten bei einer Kontakttrennung im Zeitbereich von kurz vor dem Scheitelwert einer Teilschwingung des Hochstroms bis kurz nach dem Scheitelwert dieser Teilschwingung.

Dann verbleiben bei um etwa die Hälfte reduzierter, von der Schaltkammer noch zu bewältigender thermischer Energie des Ausschaltstrom-Lichtbogens für die Kontakte des Hilfsschalters noch etwa 5 ms bis zum Erreichen der Isolierdistanz gegen die Einschwingspannung; mit einer Kontaktgeschwindigkeit von z.B. 2 m/s werden es 10 mm Isolierdistanz pro Unterbrechereinheit eines Vakuumschalters, dessen Kontakte diese Geschwindigkeit bereits bei der Trennung besitzen.

Nützlich ist auch eine Kombination der dargelegten autonomen Verfahren zur Entlastung des Hilfsschalters von der thermischen Energie des Ausschaltstrom-Lichtbogens: Reduktion des Hochstroms vor dem Strom-Null im Hilfsschalter oder verzögerte Kontakttrennung vor dem Strom-Null im Hilfsschalter. In dieser Kombination erfolgt zuerst die Maßnahme der relativ verzögerten Kontakttrennung, der sich die Maßnahme der Überlagerung des Hochstroms mit einem Gegenstrom oder auch mit zwei aufeinanderfol genden Gegenströmen anschließt.

**Patentansprüche**

1. Synthetische Prüfschaltung für Hochspannungs-Wechselstrom-Leistungsschalter
   mit einem eine Hochstromenergiequelle in Reihenschaltung mit einem Prüfschalter (TB) und mindestens einem Hilfsschalter (AB) enthaltenden, einen ersten Teil der wiederkehrenden Spannung an den Klemmen des Prüfschalters erzeugenden Hochstromkreis I und mit einem eine Hochspannungsenergiequelle enthaltenden, einen zweiten Teil der wiederkehrenden Spannung an den Klemmen des Prüfschalters erzeugenden Hochspannungskreis,
   **gekennzeichnet durch** folgende Merkmale:

   dem Hilfsschalter sind als Bauelemente der synthetischen Prüfschaltung parallelgeschaltet:

   ein Halbleiterbauelement in der Ausführungsform:

   - einer Halbleiterdiode (DI), oder
   - einer Halbleitertriode (Thyristor, TH), oder
   - einer Antiparallelschaltung von Thyristoren,

   wobei diese Bauelemente jeweils für eine bestimmte Polarität der wiederkehrenden Spannung des Hochstromkreises in Durchlaßrichtung geschaltet sind, während sie zu einer mit dieser Spannung additiv in Reihe geschalteten Spannung des Hochspannungskreises Sperrichtung aufweisen und die in der Parallelschaltung zum Hilfsschalter gegebenenfalls **durch** Thyristoren dargestellten Halbleiterbauelemente frühestens kurz vor dem Einsetzen der wiederkehrenden Spannung des Hochstromkreises bei bestehender Durchlaßrichtung gezündet werden sowie
   eine Kapazität ($C_a$) allein oder mit ohmscher Widerstandsbeschaltung.

2. Synthetische Prüfschaltung für Hochspannungs-Wechselstrom-Leistungsschalter
   mit einem eine Hochstromenergiequelle in Reihenschaltung mit einem Prüfschalter (TB) und mindestens einem Hilfsschalter (AB) enthaltenden, einen ersten Teil der wiederkehrenden Spannung an den Klemmen des Prüfschalters erzeugenden Hochstromkreis I und mit einem eine Hochspannungsenergiequelle enthaltenden, einen zweiten Teil der wiederkehrenden Spannung an den Klemmen des Prüfschalters erzeugenden Hochspannungskreis,
   **gekennzeichnet durch** folgende Merkmale:

   die Spannung ($U_h$) an der Kapazität ($C_h$) des Hochspannungskreises, die in Reihenschaltung mit der wiederkehrenden stationären Spannung $U_1$ des Hochstromkreises die synthetische stationäre Erstlöschende Polspannung an den Klemmen des Prüfschalters ergibt, reduziert ein mittels einer Schalteinrichtung erzeugter Schaltvorgang auf eine Spannung, die in Reihenschaltung mit der wiederkehrenden Spannung $U_1$ des Hochstromkreises an den Klemmen des Prüfschalters eine synthetische Spannung ergibt, die zumindest bezüglich der Spannungshöhe zumindest annähernd derjenigen stationären Spannung gleicht, die nach der Unterbrechung eines dreiphasigen Kurzschlußstroms in einem Drehstromnetz in allen drei Polen eines Leistungsschalters wiederkehrt, wobei dieser Schaltvorgang frühestens gleichzeitig mit dem Einsetzen der Einschwingspannung an den Klemmen des Prüfschalters ausgelöst wird.

3. Prüfschaltung nach Anspruch 2, **gekennzeichnet durch** folgende Merkmale:

   den Schaltvorgang , der die Spannung $U_h$ des Hochspannungskreises reduziert, macht eine aperiodisch gedämpfte Entladung einer Teikapazität ($C_{h2}$) mit der Teilspannung ($U_{h2}$) daran mittels einer Schaltfunkenstrecke (SG) aus, oder

   diesen Schaltvorgang bildet eine Umpolungsschwingung der Gesamtspannung ($U_h$) an der Gesamtkapazität ($C_h$) mittels einer Schaltfunkenstrecke ($SG_B$) mit Unterbrechungsvermögen der Halbschwingung des zugehörigen Schwingstroms, wobei die Umpolungsschwingung eine die natürliche Dämpfung ergänzende zusätzliche Dämpfung aufweist.

4. Synthetische Prüfschaltung für Hochspannungs-Wechselstrom-Leistungsschalter

mit einem eine Hochstromenergiequelle in Reihenschaltung mit einem Prüfschalter (TB) und mindestens einem Hilfsschalter (AB) enthaltenden, einen ersten Teil der wiederkehrenden Spannung an den Klemmen des Prüfschalters erzeugenden Hochstromkreis I und mit einem eine Hochspannungsenergiequelle enthaltenden, einen zweiten Teil der wiederkehrenden Spannung an den Klemmen des Prüfschalters erzeugenden Hochspannungskreis,

**gekennzeichnet durch** folgende Merkmale:

zur Glättung des Anfangsverlaufs der aus der Summe der Spannungen des Hochstromkreises I und des Hochspannungskreises II resultierenden synthetischen Einschwingspannung an den Klemmen des Prüfschalters (TB) wird die Frequenz der Einschwingspannung des Hochstromkreises ab einem bestimmten Zeitpunkt mittels einer Schalteinrichtung in Verbindung mit einer zusätzlichen Einrichtung verkleinert.

5. Prüfschaltung nach Anspruch 4, **gekennzeichnet durch** folgende Merkmale:

mittels einer Meß- und Schaltfunkenstrecke (MSG) wird der Kapazität ($C_1$) im Hochstromkreis kurz vor, im, oder kurz nach dem ersten Scheitelwert der Einschwingspannung des Hochstromkreises eine Kapazität ($C_s$) parallelgeschaltet, wobei diese Kapazität eine Spannung ($U_s$) führt, die im Zeitpunkt des Parallelschaltens gleiche Polarität sowie zumindest annähernd gleiche Höhe aufweist wie die Spannung an der Kapazität ($C_1$), oder

im Hochstromkreis ist vor dem Anschluß der Kapazität ($C_1$) an diesen Kreis ein Hilfsschalter ($AB_1$) angeordnet mit parallelgeschaltetem Halbleiterbauelement in der Ausführungsform:

- einer Halbleiterdiode DI, oder
- einer Halbleitertriode (Thyristor, TH), oder
- einer Antiparallelschaltung von Thyristoren,

wobei diese Bauelemente jeweils für eine bestimmte Polarität der wiederkehrenden Spannung des Hochstromkreises in Durchlaßrichtung geschaltet sind und die in der Parallelschaltung zum Hilfsschalter gegebenenfalls **durch** Thyristoren dargestellten Halbleiterbauelemente frühestens kurz vor dem Einsetzen der wiederkehrenden Spannung des Hochstromkreises bei bestehender Durchlaßrichtung gezündet werden.

6. Synthetische Prüfschaltung für Hochspannungs-Wechselstrom-Leistungsschalter

mit einem eine Hochstromquelle (G) in Reihenschaltung mit einem Prüfschalter ($B_t$) und mindestens einem Hilfsschalter ($B_a$) enthaltenden, einen ersten Teil der wiederkehrenden Spannung an den Klemmen des Prüfschalters erzeugenden Hochstromkreis und

mit einem im Verlauf dieses Teils der wiederkehrenden Spannung einer Parallelkapazität ($C_a$) des Hilfsschalters parallelzuschaltenden, eine auf Hochspannung aufladbare Kapazität ($C_h$) in Reihenschaltung mit einer Induktivität ($L_h$) enthaltenden Hochspannungsschwingkreis, der einen zweiten Teil der wiederkehrenden Spannung an den Klemmen des Prüfschalters erzeugt,

**gekennzeichnet durch** folgende Merkmale:

dem Hilfsschalter ist zumindest ein anfänglich offener Stromkreis bestehend aus einer auf eine Spannung aufladbaren Kapazität in Reihe mit mindestens einem strombegrenzenden Widerstand parallelgeschaltet,

und dieser Stromkreis wird vor einem Strom-Null des Hochstroms mit Unterbrechungsmöglichkeit **durch** den Prüfschalter mittels einer Schnellschalteinrichtung geschlossen,

woraufhin sich dem Hochstrom im Hilfsschalter ein Strom relativ kleineren Maximalwerts und entgegengesetzter Polarität überlagert, welcher Überlagerungsstrom spätestens im Zeitpunkt des Strom-Null des Hochstroms **durch** die Schnellschalteinrichtung unterbrochen wird.

7. Prüfschaltung nach Anspruch 1, **gekennzeichnet durch** folgende Merkmale:

dem Hilfsschalter wird vor dem letzten Strom-Null des Hochstroms ($i_1$) eine die Spannung ($U_2$) führende Kapazität ($C_2$) in Reihe mit mindestens einer Iduktivität ($L_2$) mittels einer steuerbaren im wesentlichen aus einer Vakuumschaltkammer mit feststehenden Kontakten und einer Triggerfunkenstrecke bestehenden Schnellschalteinrichtung (HSD) parallelgeschaltet,

woraufhin sich dem Hochstrom ein Schwingstrom ($i_2$) relativ kleinerer Amplitude und höherer Frequenz mit entgegengesetzter Polarität überlagert,

und dieser Überlagerungsstrom wird in einem Strom-Null spätestens zum Zeitpunkt ($t_1$) des Strom-Null des Hochstroms **durch** die Schnellschalteinrichtung unterbrochen.

8. Prüfschaltung nach Anspruch 1, **gekennzeichnet durch** folgende Merkmale:

dem Hilfsschalter wird vor dem letzten Strom-Null des Hochstroms ($i_1$) eine die Spannung ($U_2^{'}$) führende Kapazität ($C_2^{'}$) in Reihe mit mindestens einem ohmschen Widerstand ($R_2$) mittels einer steuerbaren Schaltfunkenstrecke ($SG_2$) parallelgeschaltet,

woraufhin sich dem Hochstrom ein aperiodischer Strom ($i_2^{'}$) relativ kleineren Höchstwerts mit entgegengesetzter Polarität überlagert

und dieser Überlagerungsstrom wird spätestens zum Zeitpunkt ($t_1$) des Strom-Null des Hochstroms **durch** einen Schalter ($B_2$) unterbrochen,

wobei die Schaltfunkenstrecke ($SG_2$) und der Schalter ($B_2$) die Schnellschalteinrichtung (HSD) bilden.

9. Synthetische Prüfschaltung für Hochspannungs-Wechselstrom-leistungsschalter
   mit einem eine Hochstromquelle (G) in Reihenschaltung mit einem Prüfschalter ($B_t$) und mindestens einem Hilfsschalter ($B_a$) enthaltenden, einen ersten Teil der wiederkehrenden Spannung an den Klemmen des Prüfschalters erzeugenden Hochstromkreis und
   mit einem im Verlauf dieses Teils der wiederkehrenden Spannung einer Parallelkapazität ($C_a$) des Hilfsschalters parallelzuschaltenden, eine auf eine hohe Spannung aufladbare Kapazität ($C_h$) in Reihemschaltung mit einer Induktivität ($L_h$) enthaltenden Hochspannungsschwingkreis, der einen zweiten Teil der wiederkehrenden Spannung an den Klemmen des Prüfschalters erzeugt,
   **gekennzeichnet durch** folgende Merkmale:

der Hilfsschalter ($B_a$) wird zu einem Zeitpunkt ausgelöst, nach welchem dessen Kontakte sich während-einer Teilschwingung des Hochstroms ($i_1$) mit bestehender Unterbrechungsmöglichkeit im Strom-Null **durch** den Prüfschalter in einem Zeitbereich von kurz vor dem Scheitelwert des Hochstroms bis kurz nach dem Scheitelwert des Hochstroms trennen.

10. Prüfschaltung nach Anspruch 4, **gekennzeichnet durch** folgende Merkmale:

frühestens bei der Kontakttrennung des Hilfsschalters wird dem darin fließenden Hochstrom zu dessen Reduktion zumindest ein Strom relativ kleineren Maximalwerts und entgegengesetzter Polarität überlagert,

wobei dieser Strom in einem anfänglich offenen Stromkreis fließt, welcher Stromkreis aus einer auf eine Spannung aufladbaren Kapazität in Reihe mit mindestens einem strombegrenzenden Widerstand besteht und **durch** eine Schnellschalteinrichtung zum Überlagerungszeitpunkt dem Hilfsschalter parallelgeschaltet wird;
spätestens im Zeitpunkt ($t_1$) des Strom-Null des Hochstroms unterbricht die Schnellschaltvorrichtung den Überlagerungsstrom.

Fig. 1

Fig. 2

Fig.3

EP 1 475 645 A1

Fig. 4

Fig.6

Fig.5

Fig. 7

$i_1 / B_a$

$i_1 + i_2$

$i_1$

$\tau_0$

$\tau_1$ $t_1$

*Fig. 8*

$i_2$

*Fig. 9*

$i_1 / B_t$

$t_1$

*Fig. 10*

$Fig.11$

Fig. 12

$$i_1 / B_a$$

$$i_1 + i_2'$$

$$i_1$$

$$T/4 \qquad \tau_0' \qquad \tau_1' \ t_1 \qquad t/\tau'$$

$$i_2'$$

Fig. 13

$i_1 / B_a$

*Fig. 14*

$i_1 + i_2' + i_2$

$i_2$

*Fig. 9*

$i_2'$

$\triangleq$ *Fig. 13*

**Europäisches**
**Patentamt**

## EUROPÄISCHER RECHERCHENBERICHT

Nummer der Anmeldung

EP 03 09 0137

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | DE 199 30 993 A (ASEA BROWN BOVERI) 11. Januar 2001 (2001-01-11) | 1 | G01R31/333 |
| A | * Spalte 2, Zeile 34 - Spalte 5, Zeile 46; Abbildungen 1-5 * | 4,5 | |
| | --- | | |
| X | CH 373 467 A (SIEMENS AG) 30. November 1963 (1963-11-30) | 1 | |
| A | * Seite 4, Spalte 1, Zeile 47 - Spalte 2, Zeile 72; Abbildung 1 * | 4,5 | |
| | --- | | |
| X | GB 1 036 587 A (LICENTIA GMBH) 20. Juli 1966 (1966-07-20) | 4,5 | |
| A | * Seite 2, Spalte 1, Zeile 17 - Zeile 27; Abbildung 1 * | | |
| | --- | | |
| E | EP 1 347 304 A (SLAMECKA ERNST) 24. September 2003 (2003-09-24) * Anspruch 7; Abbildungen 1,8,9 * | 6 | |
| | --- | | |
| X | DE 36 17 653 A (BBC BROWN BOVERI & CIE) 5. November 1987 (1987-11-05) * Spalte 3, Zeile 31 - Zeile 33; Abbildungen 1,2 * | 9 | RECHERCHIERTE SACHGEBIETE (Int.Cl.7) |
| | --- | | G01R |
| X | EP 0 235 389 A (BBC BROWN BOVERI & CIE) 9. September 1987 (1987-09-09) | 9 | |
| A | * Spalte 5, Zeile 43 - Zeile 44; Abbildungen 1,2,7 * | 1 | |
| | --- | | |
| A | DE 26 56 211 A (LICENTIA GMBH) 15. Juni 1978 (1978-06-15) * Abbildungen 1-3 * | 1 | |
| | --- | | |
| A | GB 1 005 942 A (LICENTIA GMBH) 29. September 1965 (1965-09-29) * das ganze Dokument * | 1 | |
| | --- | | |
| | -/-- | | |

Der vorliegende Recherchenbericht wurde für alle Patentansprüche erstellt

| Recherchenort | Abschlußdatum der Recherche | Prüfer |
|---|---|---|
| DEN HAAG | 23. Dezember 2003 | Koll, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

EP 1 475 645 A1

| | Europäisches Patentamt | **EUROPÄISCHER RECHERCHENBERICHT** | Nummer der Anmeldung<br>EP 03 09 0137 |

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | CH 343 530 A (LICENTIA GMBH)<br>31. Dezember 1959 (1959-12-31)<br>* Seite 2, Spalte 1, Zeile 31 - Spalte 2,<br>Zeile 72; Abbildung 1 *<br>--- | 4,5 | |
| A | SLAMECKA, E.: "Prüfung von Hochspannungs-Leistungsschaltern"<br>1966 , SPRINGER-VERLAG , BERLIN<br>XP002265703<br>* Seite 258, Absatz 3.4.3.1 - Seite 259;<br>Abbildungen 32,33 *<br>--- | 6-8,10 | |
| A | SU 864 196 A (LE POLT I IM M I KALININA)<br>15. September 1981 (1981-09-15)<br>* Spalte 3, Zeile 49 - Spalte 4, Zeile 36;<br>Abbildungen 1,2 *<br>----- | 7 | |
| | | | RECHERCHIERTE SACHGEBIETE (Int.Cl.7) |

Der vorliegende Recherchenbericht wurde für alle Patentansprüche erstellt

| Recherchenort | Abschlußdatum der Recherche | Prüfer |
|---|---|---|
| DEN HAAG | 23. Dezember 2003 | Koll, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

27

**ANHANG ZUM EUROPÄISCHEN RECHERCHENBERICHT**
**ÜBER DIE EUROPÄISCHE PATENTANMELDUNG NR.**                EP 03 09 0137

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-12-2003

| Im Recherchenbericht angeführtes Patentdokument | | Datum der Veröffentlichung | Mitglied(er) der Patentfamilie | | Datum der Veröffentlichung |
|---|---|---|---|---|---|
| DE 19930993 | A | 11-01-2001 | DE | 19930993 A1 | 11-01-2001 |
| | | | EP | 1074850 A2 | 07-02-2001 |
| | | | JP | 2001042013 A | 16-02-2001 |
| CH 373467 | A | 30-11-1963 | DE | 1064631 B | 03-09-1959 |
| | | | DE | 1064148 B | 27-08-1959 |
| | | | GB | 904829 A | 29-08-1962 |
| GB 1036587 | A | 20-07-1966 | CH | 401259 A | 31-10-1965 |
| EP 1347304 | A | 24-09-2003 | DE | 10214218 A1 | 02-10-2003 |
| | | | EP | 1347304 A2 | 24-09-2003 |
| DE 3617653 | A | 05-11-1987 | DE | 3617653 A1 | 05-11-1987 |
| | | | EP | 0243812 A1 | 04-11-1987 |
| EP 0235389 | A | 09-09-1987 | DE | 3675760 D1 | 03-01-1991 |
| | | | EP | 0235389 A1 | 09-09-1987 |
| | | | JP | 2550046 B2 | 30-10-1996 |
| | | | JP | 62180917 A | 08-08-1987 |
| DE 2656211 | A | 15-06-1978 | DE | 2656211 A1 | 15-06-1978 |
| GB 1005942 | A | 29-09-1965 | KEINE | | |
| CH 343530 | A | 31-12-1959 | KEINE | | |
| SU 864196 | A | 15-09-1981 | SU | 864196 A1 | 15-09-1981 |

EPO FORM P0461

Für nähere Einzelheiten zu diesem Anhang : siehe Amtsblatt des Europäischen Patentamts, Nr.12/82